Europäisches Patentamt

(19) European Patent Office

Office européen des brevets

(11) Publication number: **0 026 604**
**B1**

(12) **EUROPEAN PATENT SPECIFICATION**

(45) Date of publication of patent specification: **08.02.84**  (51) Int. Cl.³: **C 23 C  11/00**

(21) Application number: **80303229.1**

(22) Date of filing: **15.09.80**

(54) A method of vapour phase growth and apparatus therefor.

(30) Priority: **20.09.79 JP  121489/79**

(43) Date of publication of application:
**08.04.81 Bulletin 81/14**

(45) Publication of the grant of the patent:
**08.02.84 Bulletin 84/6**

(84) Designated Contracting States:
**DE FR GB NL**

(56) References cited:
**DE - A - 2 736 514**

**SOLID STATE TECHNOLOGY, vol. 19, no. 6,
June 1976, pages 45-50 R.S. ROSLER et al.: "A
production reactor for low temperature plasma-
enhanced silicon nitride deposition"
JOURNAL OF THE ELECTROCHEMICAL
SOCIETY, vol. 119, no. 9, September 1972,
pages 1248-1254 R. GERETH et al.: "Properties
of ammonia-free nitrogen-Si3-N4 films produced
at low temperatures"
APPLIED PHYSICS LETTERS, vol. 32, no. 4,
February 1978, pages 245-246 A.K. SINHA et
al.: "Lorentzlorenz correlation for reactively
plasma deposited Si-N films"**

(73) Proprietor: **FUJITSU LIMITED
1015, Kamikodanaka Nakahara-ku
Kawasaki-shi Kanagawa 211 (JP)**

(72) Inventor: **Takagi, Mikio
6-20-3, Nagao Tama-ku
Kawasaki-shi Kanagawa, 213 (JP)**
Inventor: **Takasaki, Kanetake
1-26-10-703, Ohmorikita Ohta-ku
Tokyo, 143 (JP)**
Inventor: **Koyama, Kenji
3-56 Higashihemi-cho
Yokosuka-shi Kanagawa, 238 (JP)**

(74) Representative: **Bedggood, Guy Stuart et al,
Haseltine Lake & Co. Hazlitt House 28
Southampton Buildings Chancery Lane
London WC2A 1AT (GB)**

(56) References cited:
**JAPANESE JOURNAL OF APPLIED PHYSICS,
vol. 8, no. 7, July 1969, pages 876-882 Y.
KUWANO: "Some properties of silicon nitride
films produced by radio frequency glow
discharge reaction of silance and nitrogen"
Handbook of Thin Film Technology, Maissel and
Glang, 1970 pages 4-35 to 4-39**

# 0 026 604

A method of vapour phase growth and apparatus therefore

The present invention relates to a method of vapour phase growth and apparatus therefore, and more particularly concerns a method of plasma chemical vapour deposition (CVD).

Plasma chemical vapour deposition (plasma CVD) methods have been widely used for forming desired films on substrates, for example semiconductor substrates.

In such a method, plasma is generated between oppositely arranged electrodes in a furnace tube of a reactor, and a deposit formed by chemical phase reaction of reactive gases introduced into the furnace tube is caused to attach to a substrate, for example a semiconductor substrate, placed in the reactor.

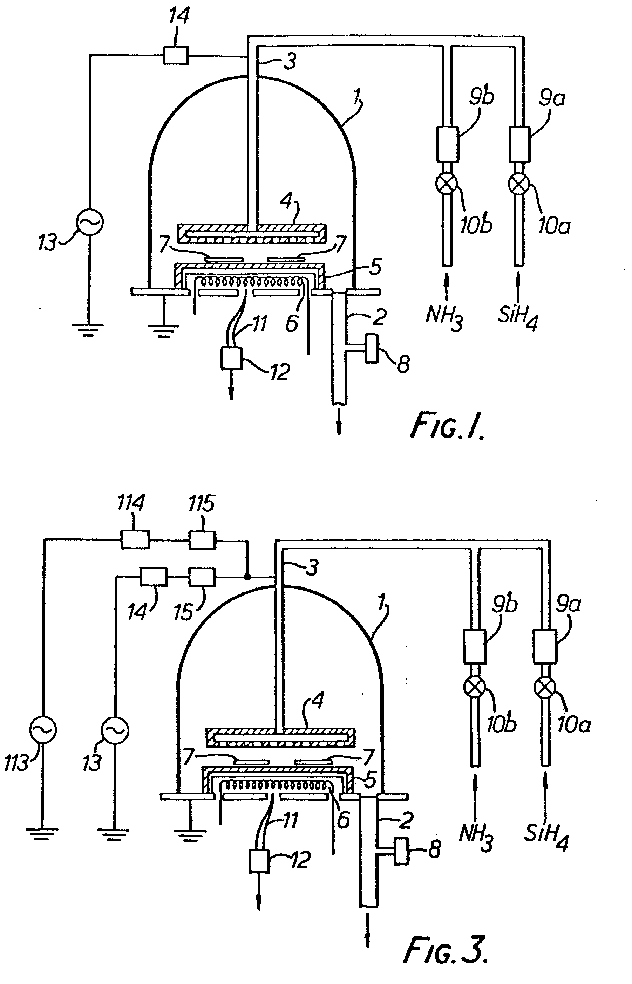

One type of plasma CVD apparatus used to carry out a method of vapour phase growth as mentioned above is schematically illustrated in Fig. 1 of the accompanying drawings, which is a schematic cross-sectional view. This apparatus is of the kind generally called parallel plate type or condenser coupled type apparatus.

If a silicon nitride film is to be attached to or grown on the surface of a semiconductor substrate, for example, air is drawn out of a reaction chamber 1 made of quartz or stainless steel (in the latter case the steel must be shielded in accordance with a conventional method) through an exhaust pipe 2 to maintain within the reaction chamber 1 a degree of vacuum in the order of a pressure of 1 Torr, which is indicated by a vacuum gauge 8. Monosilane ($SiH_4$) gas and ammonia ($NH_3$) gas are supplied via control taps or valves 10a, 10b and flow meters 9a, 9b and are introduced into the reaction chamber 1 through an inlet 3. Radio frequency power generated by a generator 13 is applied, through a conventional matching box 14, between upper and lower electrodes 4 and 5, which are arranged opposite to one another, to cause discharge therebetween. Matching box 14 is used to match output impedance of the generator 13 and input impedance of the apparatus within the reaction chamber 1. A lower part of the upper electrode 4 is a porous plate having openings therein. Lower electrode 5 provides a base of a two layer structure made of aluminum covered stainless steel. Lower electrode 5 is heated by a conventional heater 6 which is heated to 300 to 350°C. A thermocouple 11 is placed under the heater 6, and, through a suitable feedback controller 12, is connected to a conventional heat source supply, not shown, for the heater 6. Semiconductor substrates 7 are placed on the lower electrode 5 parallel to each other. Reactive gases which are introduced are caused to jet onto the substrates 7, which are heated to 300 to 350°C, through openings in the porous plate of the upper electrode 4, the gases being excited by discharge energy to effect vapour phase reaction. As a result, an $Si_3N_4$ film attaches to or grows on the semiconductor substrates 7.

The advantage of the method of vapour phase growth of the kind just described over known ordinary chemical vapour deposition is that a desired film is grown on a semiconductor substrate at temperatures in range of 300 to 350°C compared with temperatures of the order of 850°C employed in ordinary chemical vapour deposition.

In the manufacture of integrated circuits, it is desired to carry out manufacturing processes which take place after a metallization process at temperatures not exceeding 450°C, because metals having low melting points are used for the interconnection of elements of the integrated circuits. In the method explained above, the temperature within the reaction chamber never exceeds 350°C, and thus this method satisfies the temperature requirements for the manufacture of integrated circuits as just described.

The condition of a deposit grown by the method explained above depends on whether the frequency used is high or low. If a low frequency is selected, a film of high quality is produced but deposition rate is sacrificed (i.e. deposition rate is relatively slow). With a high frequency, the deposition rate is high, but the quality of the film is not satisfactory. This is a major problem encountered in a conventional method of vapour phase growth in which a radio frequency power source is utilized.

In order to confirm that the problems mentioned above do indeed arise, the conventional method of vapour phase growth was carried out using the apparatus shown in Fig. 1 under several different conditions.

For the purpose of growing a film of $Si_3N_4$ as mentioned above, a power source frequency of 400 KHz was selected. The ratio of gases introduced was set to obtain a value of $NH_3/SiH_4 = 2$. Radio frequency power in range of 10 to 30 W was used while maintaining a degree of vacuum within the reactor tube 1 at 1 Torr. Deposition rate was 150 Å/minute. Although the deposition rate is low, a fine film of $Si_3N_4$ having a small number of pinholes was grown.

Under otherwise the same conditions, the power source frequency was changed to 13.56 MHz. A high deposition rate of 500 Å/minute was achieved, but there were many pinholes, giving poorer film quality.

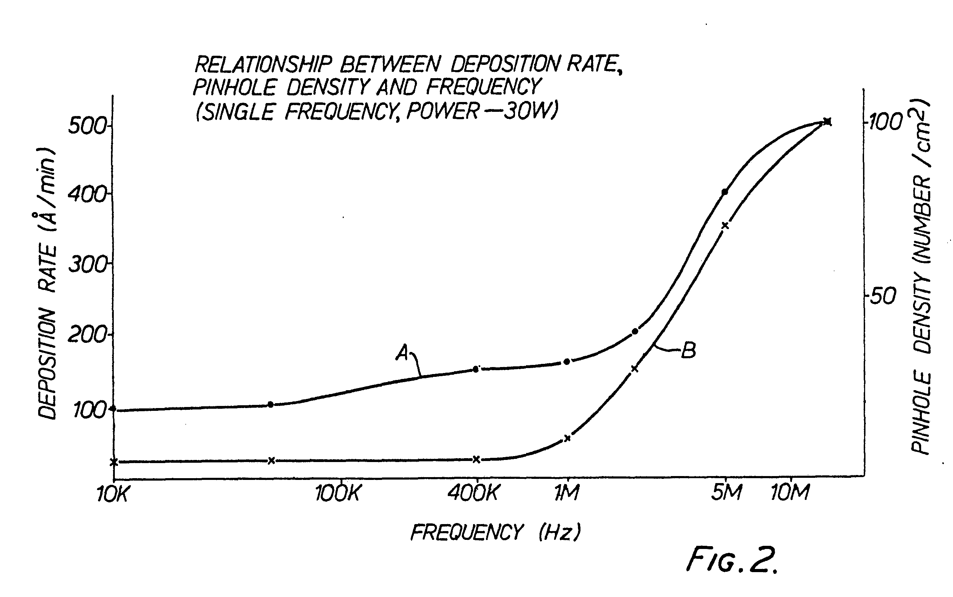

Results obtained by carrying out conventional plasma chemical vapour deposition, including the two examples just described are shown in Fig. 2 of the accompanying drawings, which graphically shows the relationship between deposition rate and the pinhole density on the one hand and power source frequency on the other. In each case applied power was 30 W, or in other terms the power

2

density per unit area of the electrode was 0.3 W/cm². In Fig. 2, the abscissa represents power source frequency, the ordinate on the left represents deposition rate and the ordinate on the right pinhole density. In Figure 2, curve A illustrates a relationship between power source frequency and deposition rate and curve B illustrates a relationship between power source frequency and pinhole density.

The inventors believe that the phenomenon occurring in conventional plasma chemical vapour deposition is due to a high rate of growth of silicon ions and nitrogen ions or silicon radicals and nitrogen radicals which bring about not only the growth of $Si_3N_4$ on the surface of the semiconductor substrate but also the falling down or precipitation and deposition of $Si_3N_4$ produced through reaction in the vapour phase.

Further, if high frequency power is applied, thermocouple 11 beneath the lower electrode 5 functions as an antenna, and thus produces noise which affects the feedback controller 12 and which is liable to cause an unwarrantable temperature rise.

On the other hand plasma generated when a low frequency power source is used is unstable.

Thus, whether a high frequency power source is used or a low frequency power source is used, there are advantages as well as disadvantages.

DE—A—2 736 514 discloses a method of vapor phase growth in which plasma is produced by applying high frequency electric power to an electrode in a reaction chamber from a first high frequency source, and by applying high frequency electric power to a further electrode provided externally of and wound around the reaction chamber from a second high frequency source.

The Handbook of Thin Film Technology, Maissel & Glang, 1970 pages 4—35 to 4—39 discloses a radio frequency sputtering system using direct current and a superimposed radio frequency voltage.

According to the present invention there is provided a mthod of vapour phase growth, for forming a film on a substrate, comprising

disposing the substrate in a reaction chamber having therein a pair of electrodes,
introducing reactive gases into the reaction chamber,
applying electric power to the pair of electrodes for exciting the reactive gases to generate a plasma to form the film on the substrate,
characterised in that the electric power is applied at a plurality of different radio frequencies simultaneously.

According to the present invention there is provided an apparatus for performing a method as set forth in the paragraph above which apparatus comprises:

a reaction chamber,
a pair of electrodes arranged opposite to one another in the reaction chamber, and upon one of which a substrate is placed for growing a film thereon,
heating means below said one electrode,
means for introducing reactive gases into the reaction chamber,
means for exhausting air from the reaction chamber, and
a radio frequency generator connected to supply radio frequency power to the electrodes, for exciting the reactive gases to generate a plasma,
characterised in that the apparatus comprises a further radio frequency generator connected also to supply radio frequency power to the electrodes, the generators supplying power at respective different radio frequencies.

An embodiment of this invention can offer a solution to the technical problem encountered in the prior art, providing for the growth of a film of superior quality at an efficient rate of deposition.

Power from different sources, generating power at different frequencies, is simultaneously applied for producing an electric discharge to excite reactive gases. More particularly, a plurality of radio frequency power sources of different frequencies are employed as power sources for exciting reactive gases, whereupon the reactive gases are excited to cause a desired film to be grown on a semiconductor substrate.

Reference is made, by way of example, to the accompanying drawings, in which:—

Fig. 1 as mentioned above, is a schematic cross-sectional view illustrating an apparatus used previously to carry out plasma chemical vapour deposition;

Fig. 2 as mentioned above, is a graph illustrating relationships between deposition rate and pinhole density (expressed in terms of the number of pinholes per unit area) on the one hand and the frequency (hz) of a radio frequency power source on the other hand, in previously proposed plasma chemical vapour deposition;

Fig. 3 is a schematic cross-sectional view illustrating an apparatus for effecting plasma chemical vapour deposition according to an embodiment of the present invention;

Fig. 4, which concerns a preferred embodiment of the present invention, is a graph illustrating relationships between deposition rate and the pinhole density (expressed by the number of pinholes per unit area) on the one hand and applied electric power on the other hand;

3

Figures 5 to 7, which concern other embodiments of the present invention, are respective graphs similar to that of Fig. 4; and

Figures 8 and 9 are graphs similar to that of Fig. 4 but illustrate two examples in which satisfactory results are not achieved.

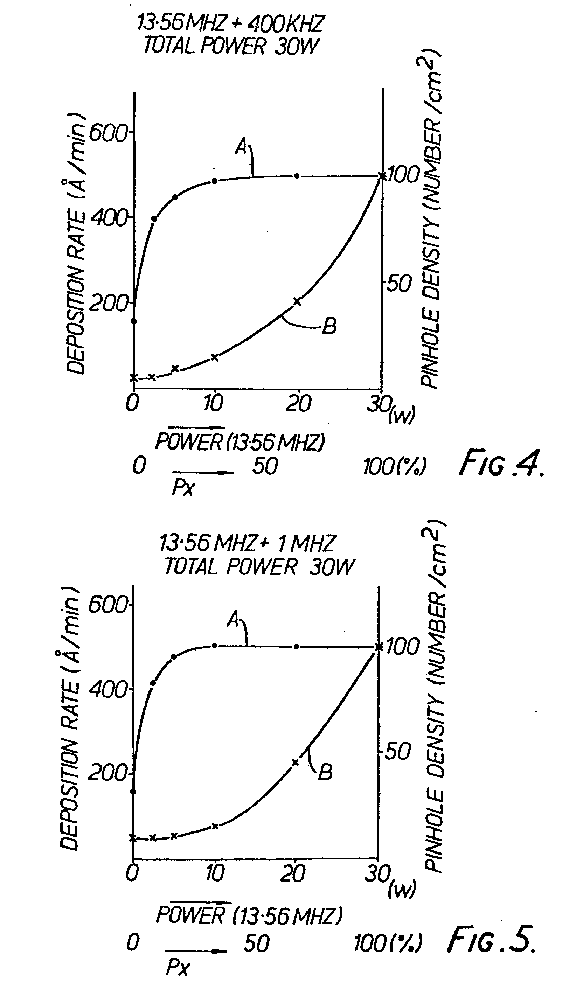

In an embodiment of the present invention, electric power is applied simultaneously from a high frequency power source and from a low frequency power source, to overcome the technical problems described above. An apparatus embodying the present invention is schematically shown in Fig. 3 in cross-section. In Fig. 3 parts similar to those illustrated in Fig. 1 are given the same reference numerals.

A generator 13 generates 5 W power (or a power density of 0.05 W per unit area of electrode) at a frequency of 13.56 MHz which is applied to upper and lower electrodes 4 and 5 through a matching box 14 and a conventional high-pass filter 15 which cuts off frequencies below 5 MHz. A generator 113 generates 25 W power (or power density of 0.25W per unit area of the electrode) at a frequency of 400 KHz which is similarly applied to upper and lower electrodes 4 and 5 through a conventional matching box 114 and a conventional low-pass filter 115 which cuts off frequencies higher than 1 MHz. Thus, two different frequencies are superimposed or mixed, to generate a total power of 30 W, to cause electric discharge.

The inventors have found that by applying radio frequency power at at least two different frequencies, as described above, results can be obtained in which, surprisingly, only the advantages of the individual frequencies are present.

Fig. 4 is a graph illustrating relationships between 13.56 MHz power ( or the power ratio Px of the two frequencies 13.56 MHz and 400 KHz), deposition rate in Å/minute and pinhole density expressed as the number of pinholes /cm$^2$ in the growth of a film of $Si_3N_4$ in the manner described above using the apparatus shown in Fig. 3. In Fig. 4, curve A illustrates a relationship between 13.56 MHz power (or power ratio Px) and deposition rate, and curve B illustrates a relationship between 13.56 MHz power (or power ratio Px) and pinhole density.

Power ratio Px is a value expressed by:

$$Px = \frac{\text{power of 13.56 MHz frequency}}{\text{(power of 13.56 MHz frequency)} + \text{(power of 400 KHz frequency)}} \times 100 \ (\%)$$

The total power was maintained at a constant value of 30 W, or a power density of 0.3 W/cm$^2$ as described above.

As will be understood from examination of the graph of Fig. 4, a relatively high deposition rate of 400 Å/minute was obtained with a relatively small pinhole density of 7/cm$^2$ to 15/cm$^2$ when 13.56 MHz power was approximately 2.5 to 10 W (or, in terms of power density,0.025/cm$^2$ to 0.1/cm$^2$) and 400 KHz power was approximately 27.5 to 20 W (in power density terms 0.275 W/cm$^2$ to 0.2 W/cm$^2$). Namely, the power ratio Px was approximately 8.3 to 33.3%.

Further embodiments of the invention will be described hereinafter.

The graphs of Figures 5, 6 and 7 concern three further embodiments of the present invention in all of which a total power of 30 W was applied (in other terms the power density per unit area of electrode was 0.3 W/cm$^3$). In each graph, the ordinate on the left represents deposition rate and the ordinate on the right pinhole density (expressed as the number of pinholes in unit area of the film). In Figs. 5, 6 and 7 curves A illustrate relationships between "high frequency" (or power ratio) and deposition rate, and curves B illustrate relationships between the "high frequency" power (or power ratio) and pinhole density. The abscissas in Figs. 5 to 7 represent the power as follows:

in Fig. 5, the power and the power ratio from a generator of 13.56 MHz power,

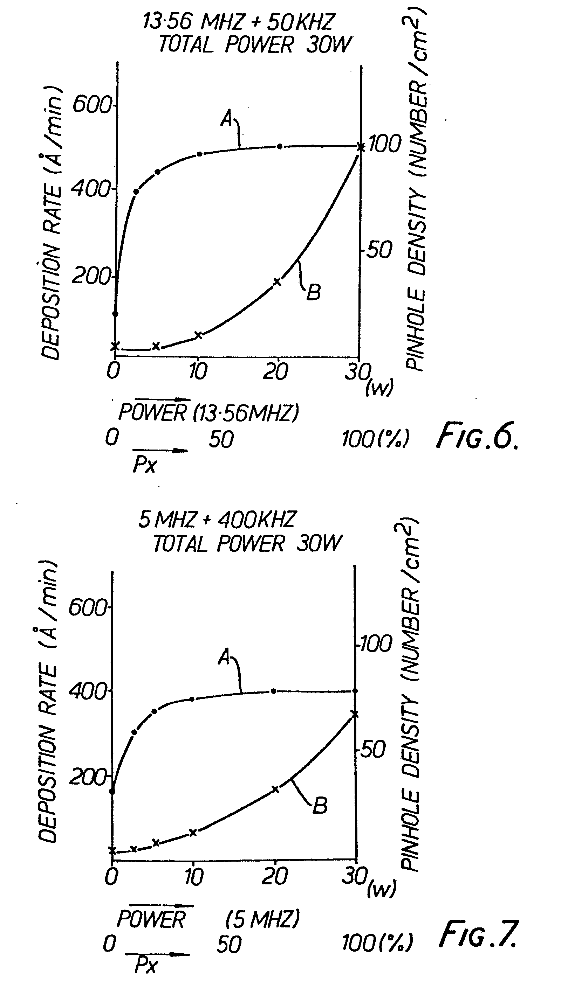

in Fig. 6, the power and the power ratio from a generator of 13.56 MHz power, and

in Fig. 7, the power and the power ratio from a generator of 5 MHz power.

The power and the power ratio of the source of the other frequency (the "low frequency") can be obtained in each case by subtracting the values represented on the abscissas from 30 W and 1.00% respectively.

Good results, the provision of a film with a small number of pinholes at a relatively high deposition rate, were obtained in each case when the power from the generator of the high frequency was of order of 2.5 to 10 W, i.e. when the power density was of order of 0.025 to 0.1 W per unit area of electrode, or when the power ratio was of order 8.3 to 33.3%.

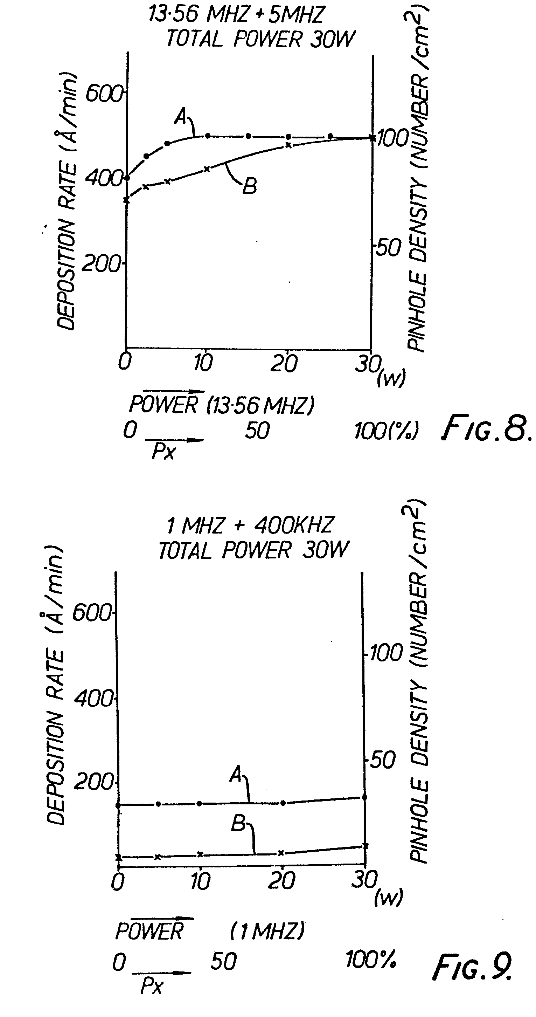

In contrast to the above, two examples illustrated in Figures 8 and 9 illustrate limitations in terms of deposition rate and pinhole density.

Fig. 8 shows results for a case in which a total power of 30 W, or power of 0.3 W power density per unit area of electrode, was applied from two sources generating at 13.56 MHz and 5 MHz respectively. As will be apparent from the graph of Fig. 8, high deposition rates (curve A) are prevalent but pinhole densities (curve B) are high.

On the other hand, in a case in which a total power of 30 W (or power density of 0.3 W per unit area of the electrode) was applied from two sources generating at 1 MHz and 400 KHz respectively, the results are as illustrated in the graph of Fig. 9, pinhole densities (curve B) are low, but deposition rates (curve A) are almost constantly low also.

Thus, technical results as enumerated below were found to be the result of mixing two frequencies:

(1) Pinhole density is high (70 pinholes per unit area of the film grown) when frequencies both higher than 5 MHz were mixed.

(2) Deposition rate is not improved (less than 200 Å/minute) when frequencies both lower than 1 MHz were mixed.

(3) If MHz frequency and a frequency lower than 1 MHz were mixed, the result is the same as when 13.56 MHz and 1 MHz were mixed.

(4) In order to decrease the pinhole density (less than 15 pinholes per unit area of the film grown), the lower frequency must be maintained at or below 1 MHz.

(5) In order to increase the deposition rate (300 Å/minute or more), the higher frequency must be maintained at or higher than 5 MHz.

As will be understood from the foregoing description of embodiments concerning the deposition of films of $Si_3N_4$, chemical vapour deposition films of good quality were grown without impairing the yield by properly selecting the ratio of high frequency and low frequency powers.

Therefore, a CVD film of good quality can be grown at a low cost according to a method embodying the present invention. It is apparent that the invention can contribute substantially not only in the manufacture of electronic components such as semiconductor chips, but also in the development of electronics industry.

It is to be pointed out further that, although the above embodiments concern the forming of films of $Si_3N_4$, the present invention is not limited thereto and may be used to grow films of, for example, silicon dioxide ($SiO_2$), amorphous silicon, phosphosilicate glass.

Further, although the above embodiments were explained with reference to condenser coupled type plasma CVD apparatus, the present invention is not limited thereto and, for example, it is also applicable to the well known inductive coupling type plasma CVD apparatus.

Thus, in a method of plasma chemical vapour deposition to form a film on a substrate placed on one of two electrodes opposite to one another within a reaction chamber of a reactor, a plurality of powers of different frequencies are applied to generate plasma between the electrodes. The plasma excites reactive gases introduced into the reaction chamber, whereby reactive gases are excited to form a desired film on the substrate. A film with a small number of pinholes was formed at a relatively high deposition rate by combinations of for example 13.56 MHz power and 1 MHz power, 13.56 MHz power and 50 KHz power, 5 MHz power and 400 KHz power.

## Claims

1. A method of vapour phase growth, for forming a film on a substrate, comprising

disposing the substrate in a reaction chamber having therein a pair of electrodes,

introducing reactive gases into the reaction chamber,

applying electric power to the pair of electrodes for exciting the reactive gases to generate a plasma to form the film on the substrate,

characterised in that the electric power is applied at a plurality of different radio frequencies simultaneously.

2. A method as claimed in claim 1, wherein the substrate is disposed on one electrode of the said pair of electrodes.

3. A method as claimed in claim 2, wherein the said one electrode is heated to a temperature of 300°C to 350°C.

4. A method as claimed in claim 1, 2 or 3, wherein the electric power is applied at a "high" frequency of 5 MHz or more, and at a "low" frequency of 1 MHz or less.

5. A method as claimed in claim 4, wherein the power ratio of the two different frequencies is of the order of from 8.3% to 33.3%

$$(\text{power ratio} = \frac{\text{power of higher frequency} \times 100\%)}{\text{total power.}}$$

6. A method as claimed in claim 5, wherein the electric power is applied at a "high" frequency of 13.56 MHz and at a "low" frequency of 400KHz.

7. A method as claimed in claim 6, wherein a total 30 W power is applied.

8. A method as claimed in any preceding claim, wherein the reactive gases are silane and ammonia and the film formed is of silicon nitride.

9. An apparatus for performing a method as claimed in any preceding claim, which apparatus comprises:

a reaction chamber,

a pair of electrodes arranged opposite to one another in the reaction chamber, and upon one of which a substrate is placed for growing a film thereon,

heating means below said one electrode,

means for introducing reactive gases into the reaction chamber,

means for exhausting air from the reaction chamber, and

a radio frequency generator connected to supply radio frequency power to the electrodes, for exciting the reactive gases to generate a plasma,

characterised in that the apparatus comprises a further radio frequency generator connected also to supply radio frequency power to the electrodes, the generators supplying power at respective different radio frequencies.

10. Apparatus as claimed in claim 9, wherein the respective radio frequency generators are connected to supply power to the electrodes through respective filters, one of which is a high-pass filter and the other of which is a low-pass filter.

**Patentansprüche**

1. Verfahren zum Wachstum aus der Dampfphase zur Bildung einer Schicht auf einem Substrat, bei welchem

das Substrat in einer Reaktionskammer angeordnet wird, welche eine Paar von Elektroden enthält, reaktionsfähige Gase in die Reaktionskammer eingeführt werden, und

dem Elektrodenpaar elektrische Energie zugeführt wird, um die reaktionsfähigen Gase anzuregen um ein Plasma zu erzeugen um eine Schicht auf dem Substrat zu bilden,

dadurch gekennzeichnet, daß die elektrische Energie als eine Mehrzahl von verschiedenen Hochfrequenzen gleichzeitig zugeführt wird.

2. Verfahren nach Anspruch 1, bei welchem das Substrat auf einer Elektrode des genannten Elektrodenpaares angeordnet ist.

3. Verfahren nach Anspruch 2, bei welchem die genannte Elektrode auf eine Temperatur von 300°C bis 350°C aufgeheizt wird.

4. Verfahren nach einem der Ansprüche 1, 2 oder 3, bei welchem die elektrische Energie als "hohe" Frequenz von 5 MHz oder höher und als eine "niedrige" Frequenz von 1 MHz oder niedriger zugeführt wird.

5. Verfahren nach Anspruch 4, bei welchem das Leistungsverhältnis der beiden verschiedenen Frequenzen in der Größenordnung von 8,3% bis 33,3% liegt.

$$\text{Leistungsverhältnis} = \frac{\text{Leistung der höheren Frequenz} \times 100\%}{\text{Gesamtleistung}}$$

6. Verfahren nach Anspruch 5, bei welchem die elektrische Energie als "hohe" Frequenz von 13,56 MHz und als "niedrige" Frequenz von 400 KHz zugeführt wird.

7. Verfahren nach Anspruch 6, bei welchem insgesamt eine Leistung von 30 W angewendet wird.

8. Verfahren nach einem der vorhergehenden Ansprüche, bei welchem die reaktionsfähigen Gase Silan und Ammoniak sind und die gebildete Schicht aus Siliziumitrid besteht.

9. Apparat zur Durchführung eines Verfahrens nach einem der vorhergehenden Ansprüche, mit einer Reaktionskammer, einem Paar von Elektroden, welche einander gegenüber in der Reaktionskammer angeordnet sind und auf deren eine ein Substrat angeordnet wird, un auf diesem eine Schicht aufzuwachsen, einer Heizung unter der genannten einen Elektrode, einer Einrichtung zur Einführung der reaktiven Gase in die Reaktionskammer, einer Einrichtung zum Abführen von Luft aus der Reaktionskammer, und mit einem Hochfrequenzgenerator, welcher den Elektroden Hochfrequenzenergie zuführt, um die reaktiven Gase anzuregen um ein Plasma zu erzeugen, dadurch gekennzeichnet, daß in dem Apparat ein weiterer Hochfrequenzgenerator zur Zuführung von ebenfalls Hochfrequenzenergie zu den Elektroden vorgesehen ist, und die Generatoren die Energie bei entsprechend verschiedenen Hochfrequenzen zuführen.

10. Vorrichtung nach Anspruch 8, bei welcher die jeweiligen Hochfrequenzgeneratoren so angeschlossen sind, daß sie den Elektroden die Energie durch entsprechende Filter zuführen, von denen eines ein Hochpaßfilter und das andere ein Tiefpaßfilter ist.

**Revendications**

1. Un procédé de croissance en phase vapeur, pour former une couche sur un substrat, dans lequel:

on place le substrat dans une chambre de réaction contenant une paire d'électrodes,
on introduit des gaz réactifs dans la chambre de réaction,
on applique de l'énergie électrique à la paire d'électrodes pour exciter les gaz réactifs afin de produire un plasma pour former la couche sur le substrat,
caractérisé en ce qu'on applique simultanément l'énergie électrique à plusieurs radiofréquences différentes.

2. Un procédé selon la revendication 1, dans lequel on place le substrat sur une électrode de la paire d'électrodes.

3. Un procédé selon la revendication 2, dans lequel on chauffe ladite électrode à une température de 300°C à 350°C.

4. Un procédé selon la revendication 1, 2 ou 3, dans lequel on applique l'énergie électrique à une fréquence "élevée" de 5 MHz ou plus, et à une fréquence "basse" de 1 MHz ou moins.

5. Un procédé selon la revendication 4, dans lequel le rapport de puissance des deux fréquences différentes est de l'ordre de 8,3% à 33,3%

$$(\text{rapport de puissance} = \frac{\text{puissance de fréquence supérieure} \times 100\%)}{\text{puissance totale}}$$

6. Une procédé selon la revendication 5, dans lequel l'énergie électrique est appliquée à une fréquence "élevée" de 13,56 MHz et à une fréquence "basse" de 400 KHz.

7. Un procédé selon la revendication 6, dans lequel on applique une puissance totale de 30 W.

8. Un procédé selon n'importe quelle revendication précédente, dans lequel les gaz réactifs sont du silane et de l'ammoniac et la couche formée consiste en nitrure de silicium.

9. Un appareil pour mettre en oeuvre un procédé selon n'importe quelle revendication précédente, cet appareil comprenant:

une chambre de réaction,
une paire d'électrodes placées face à face dans la chambre de réaction, et sur l'une desquelles un substrat est placé pour faire croître une couche sur lui,
des moyens de chauffage au-dessous de ladite électrode,
des moyens pour introduire des gaz réactifs dans la chambre de réaction,
des moyens pour évacuer l'air hors de la chambre de réaction, et
un générateur radiofréquence connecté de façon à fournir de l'énergie radiofréquence aux électrodes, pour exciter les gaz réactifs afin de produire un plasma,
caractérisé en ce que l'appareil comprend un génératueur radiofréquence supplémentaire qui est également connecté de façon à fournir de l'énergie radiofréquence aux électrodes, les générateurs fournissant de l'énergie à des radiofréquences différentes respectives.

10. Appareil selon la revendication 8, dans lequel les générateurs radiofréquences respectifs sont connectés de façon à fournir de l'énergie aux électrodes par l'intermédiaire de filtres respectifs, dont l'un est un filtre passe-haut et l'autre est un filtre passe-bas.

FIG. I.

FIG. 3.

RELATIONSHIP BETWEEN DEPOSITION RATE,
PINHOLE DENSITY AND FREQUENCY
(SINGLE FREQUENCY, POWER—30W)

FIG.2.

0 026 604

13·56 MHZ + 400 KHZ
TOTAL POWER 30W

FIG.4.

13·56 MHZ + 1 MHZ
TOTAL POWER 30W

FIG.5.

3

FIG.6.

13·56 MHZ + 50 KHZ
TOTAL POWER 30W

FIG.7.

5 MHZ + 400 KHZ
TOTAL POWER 30W

**0 026 604**

Fig. 8: 13·56 MHZ + 5MHZ, TOTAL POWER 30W — DEPOSITION RATE (Å/min) and PINHOLE DENSITY (NUMBER/cm²) vs POWER (13·56 MHZ), curves A and B.

FIG.8.

Fig. 9: 1 MHZ + 400KHZ, TOTAL POWER 30W — DEPOSITION RATE (Å/min) and PINHOLE DENSITY (NUMBER/cm²) vs POWER (1 MHZ), curves A and B.

FIG.9.